# EUROPÄISCHE PATENTSCHRIFT

(11) **EP 2 663 870 B1**
(45) Veröffentlichungstag und Bekanntmachung des Hinweises auf die Patenterteilung: **10.04.2019**
(21) Anmeldenummer: 12700546.0
(22) Anmeldetag: 03.01.2012
(51) Int. Cl.: G01R 1/073, G01R 31/26

(54) **SCHIENE FÜR DIE ELEKTRISCHE KONTAKTIERUNG EINES ELEKTRISCH LEITFÄHIGEN SUBSTRATES**
BAR FOR ELECTRICALLY CONTACTING AN ELECTRICALLY CONDUCTIVE SUBSTRATE
RAIL POUR LA MISE EN CONTACT ÉLECTRIQUE D'UN SUBSTRAT ÉLECTROCONDUCTEUR

(30) Priorität: 11.01.2011 DE 102011008261
(43) Veröffentlichungstag der Anmeldung: 20.11.2013
(73) Patentinhaber: Fraunhofer-Gesellschaft zur Förderung der angewandten Forschung e.V., 80686 München (DE)
(72) Erfinder: WIRTH, Harry, 79249 Merzhausen (DE); WALTER, Johann, 79104 Freiburg (DE)
(86) Internationale Anmeldenummer: PCT/EP2012/000012
(87) Internationale Veröffentlichungsnummer: WO 2012/095275

(56) Entgegenhaltungen:
- EP-A1- 0 078 339
- WO-A1-2006/026346
- DE-A1-102008 038 184
- DE-A1-102008 038 186
- US-A1- 2004 127 073
- US-A1- 2007 068 567
- US-A1- 2009 256 583

## Beschreibung

Die vorliegende Erfindung betrifft eine Schiene für die elektrische Kontaktierung eines elektrisch leitfähigen Substrates in Form eines dünnen, elektrisch leitenden und federnden Kontakts. Die Schiene umfasst eine Stromsammelschiene, an die eine Mehrzahl von Kontaktfingern angebracht ist. Die Erfindung zeichnet sich dadurch aus, dass die Kontaktfinger in Richtung des herzustellenden Kontaktes federnd ausgestaltet sind.

Zur Vermessung von Solarzellen ohne Zellverbinder müssen die Busbars oder Kontaktpads elektrisch durch Andruck oder Unterdruck kontaktiert werden. So kann die Zelle geflasht oder ihre Lumineszenz untersucht werden. Dies sind wichtige Verfahren für die qualitative und quantitative Bewertung von Solarzellen.

Bisher wurde dieses Problem über gefederte Kontaktstifte gelöst. Hersteller dieser sind z.B. Ingun Prüfmittelbau GmbH oder Tekon Prüftechnik GmbH.

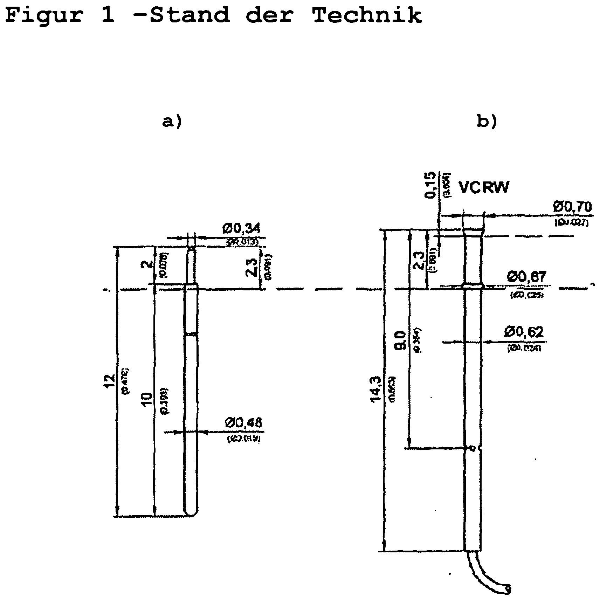

In Figur 1a) ist ein entsprechender Kontaktstift der Firma Tekon (Mikrokontaktstift Serie 0006MC) dargestellt; Figur 1b) zeigt eine entsprechende Hülse für diesen Kontaktstift (Serie 0006MC) (Quelle: Tekon Prüfmitteltechnik GmbH: Kontaktstifte Katalog 2009, Weinstadt).

Derartige Kontaktstifte werden zur elektrischen Kontaktierung von beispielsweise Solarzellen eingesetzt, um beispielsweise über Flasher-Messungen (Flasher) bzw. Photo- oder Elektrolumineszenz-Messungen bestimmte Parameter dieser Solarzellen zu ermitteln. Dabei werden die Solarzellen beispielsweise über ihre Busbars mit den Kontaktstiften elektrisch kontaktiert. Typische Busbar-Breiten liegen dabei zwischen 1,5 und 2,4 mm. Aufgrund ihrer Bauart verdecken derartige Kontaktstifte entlang des Busbars allerdings aufgrund ihrer Breite einen Teil der Solarzelle, so dass es bei den im Voranstehenden beschriebenen Prüfmethoden z.T. zur Verfälschung der erhaltenen Messwerte bzw. Ergebnisse kommt.

Aus der EP 0 078 339 ist eine Tastkopfanordnung für Leiterzugüberprüfung bekannt, die mindestens einen, eine Vielzahl von federnden Kontakten aufweisenden Tastkopf aufweist. Die federnden Kontakte weisen dabei eine gewisse Flexibilität auf, so dass bei seitlichem Aufbringen des Tastkopfes auf das zu kontaktierende Substrat durch Verbiegen der Kontakte eine Federwirkung erzielt wird. Eine derartige Tastkopfanordnung ist jedoch denkbar ungeeignet für die oben angesprochenen Überprüfungsmethoden von Solarzellen, da durch die seitliche Anordnung eine großflächige Abschattung der Solarzelle erfolgt, so dass die Solarzelle weder effizient mit Licht bestrahlt, noch bei entsprechenden Lumineszenz-Messungen die Lumineszenz vollständig aufgezeichnet werden kann. Auch eine derartige Tastkopfanordnung führt daher zu einer Verfälschung der bei den oben genannten Prüfverfahren erzielten Ergebnisse. Ferner ist ebenso eine senkrechte Kontaktierung der Solarzelle mit der Tastkopfanordnung nicht vorteilhaft, da die Kontakte eine Federwirkung aufweisen, die in der entsprechenden Ebene, die den Tastkopf bildet, ausgebildet wäre. Bei einer entsprechenden senkrechten Kontaktierung einer Solarzelle mit einem derartigen Tastkopf käme es demnach bei bestimmten Anpressdrücken zur Beschädigung oder gar zur Zerstörung der zu untersuchenden Solarzelle.

Die US 2007/0068567 A1 betrifft eine Vorrichtung zur temporären elektrischen Kontaktierung einer Solarzelle, die u.a. derart ausgebildet sein kann, dass ein elektrischer Leiter, der an einem durchgehend ausgebildeten Block fixiert ist, über eine Mehrzahl federnder Elemente an einer Schiene gelagert ist. Nachteilig bei einer derartigen Ausführungsform ist allerdings, dass beispielsweise für den Fall, dass auf der Oberfläche der Solarzelle Unebenheiten vorliegen, dadurch ein teilweises Abheben des elektrischen Kontaktes von der Oberfläche der zu kontaktierenden Solarzelle stattfindet, und dadurch eine lediglich partielle Kontaktierung der Solarzelle erfolgt. Auch hierdurch werden die erhaltenen Messergebnisse verfälscht, die hier beschriebene Kontaktvorrichtung ist ebenso wenig für eine verlässliche Kontaktierung einer Solarzelle geeignet.

Auch aus der DE 10 2008 038 186 A1 ist eine Sonde zur temporären elektrischen Kontaktierung einer Solarzelle zu Prüfzwecken bekannt, die eine Mehrzahl von Kontaktelementen, die kammartig an einer Schiene nebeneinander angeordnet sind, aufweist. Auch bei dieser Vorrichtung ist lediglich eine Federwirkung, die aus der Ebene der Schiene hinaus verläuft, zu verzeichnen; die Biegefedern sind in Richtung des herzustellenden Kontaktes jedoch starr ausgebildet. Somit gehen auch hier die Nachteile einher, wie sie auch schon oben bei den Kontaktelementen der EP 0 078 339 beschrieben wurden.

Ausgehend hiervon ist es daher Aufgabe der vorliegenden Erfindung, eine Schiene zur temporären Kontaktierung von beispielsweise Solarzellen anzugeben, mit der sich die oben genannten Nachteile vermeiden lassen.

Diese Aufgabe wird bezüglich der Schiene mit den Merkmalen des Patentanspruchs 1, bezüglich des Herstellungsverfahrens der Schiene mit den Merkmalen des Patentanspruchs 15 sowie bezüglich eines Überprüfungsverfahrens einer Solarzelle mit den Merkmalen des Patentanspruchs 16 gelöst. Die jeweiligen abhängigen Patentansprüche stellen dabei vorteilhafte Weiterbildungen dar.

Erfindungsgemäß wird somit eine Schiene für die elektrische Kontaktierung eines elektrisch leitfähigen Substrates bereitgestellt, die eine in x-Richtung länglich ausgebildete und in y-Richtung eine gewisse Dicke aufweisende Stromsammelschiene umfasst, die eine Mehrzahl von einseitig an der Stromsammelschiene angeordneten Kontaktfingern, die eine Richtungskomponente in Richtung der herzustellenden Kontaktierung (z-Richtung) aufweisen, wobei die Stromsammelschiene und die Kontaktfinger einstückig ausgebildet sind. Erfindungswesentlich dabei ist, dass die Kontaktfinger in z-Richtung federnd ausgestaltet sind.

Die erfindungsgemäße Lösung umfasst somit eine Schiene, die prinzipiell in zwei funktionelle Einheiten aufgeteilt ist, nämlich eine Stromsammelschiene, die bevorzugt durchgehend ausgebildet ist, sowie einseitig von dieser Stromsammelschiene ausgehende Kontaktfinger, die mit der Stromsammelschiene elektrisch verbunden sind. Die Stromsammelschiene dient nicht nur zur Stromführung, sondern zusätzlich zur mechanischen Stabilisierung der Kontaktschiene gegen Kräfte von außen. Die erfindungsgemäße Schiene weist dabei eine Dimensionierung auf, in der die Schiene länglich ausgebildet ist (x-Richtung); die Tiefe oder Dicke der Stromsammelschiene ist als y-Richtung definiert. Die Richtung, in der eine Kontaktierung der Schiene mit einem Substrat, beispielsweise einer Solarzelle, erfolgen soll (und in der die Kontaktfinger von der Stromsammelschiene abzweigen) ist als z-Richtung definiert. Erfindungswesentlich ist nun, dass jeder der Kontaktfinger derart ausgestaltet ist, dass eine Federwirkung in z-Richtung gegeben ist, so dass bei Kontaktierung der Schiene mit einem zu kontaktierenden Substrat, z.B. indem die Schiene in z-Richtung mit den Kontaktfingern über die Spitzen der Kontaktfinger mit dem zu kontaktierenden Substrat in Berührung gebracht wird, eine Abfederung und dadurch Reduzierung der wirkenden Anpresskraft gegeben ist.

Dies hat einerseits den Vorteil, dass eine Vielzahl von Kontaktpunkten auf der Solarzelle selbst hergestellt werden kann. Andererseits kann durch die Federwirkung eines jeden Kontaktes einer übermäßigen Krafteinwirkung auf die Solarzellenoberfläche und somit einer Beschädigung oder gar Zerstörung der Solarzelle nachhaltig entgegen gewirkt werden. Weiter hat es sich als vorteilhaft erwiesen, dass insbesondere für den Fall, dass die Schiene eine äußerst geringe Dimensionierung in y-Richtung, d.h. eine geringe Dicke, aufweist, eine großflächige Abschattung der Solarzelle vermieden werden kann. Somit ist ein im Wesentlichen ungestörter Lichteinfall auf die Solarzelle (in z-Richtung), aber auch, z.B. für den Fall einer Photo- bzw. Elektro-Lumineszenz-Messung, eine weitgehend ungehinderte Lichtemission (ebenso in z-Richtung) aus der Solarzelle gewährleistet.

Im Gegensatz zur aus der zuvor zitierten EP 0 078 339 zitierten Lösung sieht vorliegende Erfindung eine Geometrie der Einzelfinger vor, die eine Federwirkung in der Blechebene (z-Richtung) entfalten. Dadurch ist ein senkrechter Andruck auf den Probenkörper, beispielsweise eine Solarzelle bei minimaler Verschattung möglich. Im Gegensatz zur US 2007/0068567 zeichnet sich die erfindungsgemäße Lösung durch elastische, aus der Folie herausgearbeitete Finger aus. Im Gegensatz zu der aus der DE 10 2008 038 186 bekannten Sonde ist die erfindungsgemäße Sonde einstückig hergestellt, besteht somit also nicht aus Einzelteilen und ist daher viel einfacher herzustellen, flacher bezüglich der Verschattung und es sind dichtere Fingerabstände realisierbar.

Besonders bevorzugte Ausführungsformen der erfindungsgemäßen Schiene werden nachfolgend beschrieben.

Vorteilhaft ist beispielsweise, wenn die federnde Ausgestaltung der Kontaktfinger dadurch bedingt ist, dass der Winkel, der zwischen der x-Richtung und dem Verlauf der Kontaktfinger ausgebildet ist, zwischen 10° und 70°, bevorzugt zwischen 15° und 50°, weiter bevorzugt zwischen 20 und 40°, besonders bevorzugt zwischen 25° und 35° beträgt. Gemäß dieser Ausführungsform sind die Kontaktfinger abgewinkelt bezüglich der Stromsammelschiene angebracht. Die Abwinklung erfolgt jedoch dabei in der x-/z-Richtung, so dass der Verlauf der Kontaktfinger in z-Richtung im Wesentlichen vollständig bzw. vollständig von der Stromsammelschiene verdeckt ist. In Projektion in z-Richtung ist die Schiene daher ebenso sehr dünn ausgebildet. Beim Andrücken in z-Richtung der Schiene auf das zu kontaktierende Substrat erfolgt durch die abgewinkelte Anordnung der Kontaktfinger ein weiteres Abknicken der Kontaktfinger, wodurch die Federwirkung gegeben ist.

Alternativ oder zusätzlich hierzu kann die federnde Ausgestaltung der Kontaktfinger dadurch erfolgen, dass die Kontaktfinger einen nicht geradlinigen Verlauf, insbesondere einen geschwungenen oder bogenförmigen Verlauf, aufweisen.

Gemäß dieser Ausführungsform ist vorgesehen, dass durch einen nicht geradlinigen Verlauf der Kontaktfinger die Federwirkung erfolgen kann. In einer besonders bevorzugten Ausführungsform ist der geschwungene oder bogenförmige Verlauf der Kontaktfinger derart ausgebildet, dass die Kontaktfinger in Projektion in z-Richtung ebenso von der Stromsammelschiene verdeckt werden, d.h. der geschwungene oder bogenförmige Verlauf der Kontaktfinger in der x-/z-Ebene der Schiene festgelegt ist.

Vorteilhaft ist weiterhin, wenn die Spitzen der Kontaktfinger abgerundet und/oder abgeflacht ausgestaltet sind. Durch eine Abrundung der Spitzen kann ein flächigerer Kontakt gewährleistet werden und somit der Kontaktwiderstand reduziert werden.

Zudem ist gemäß einer weiteren vorteilhaften Ausführungsform vorgesehen, dass die Kontaktfinger parallel und/oder äquidistant angeordnet sind.

Bevorzugt ist ebenso, wenn der Abstand der Kontaktfinger zueinander weniger als 2 mm, bevorzugt weniger als 1 mm, besonders bevorzugt zwischen 0,05 und 0,5 mm, insbesondere zwischen 0,12 und 0,15 mm beträgt.

Weiterhin ist vorteilhaft, wenn die Länge aller Kontaktfinger gleich ist.

In einer weiteren vorteilhaften Ausführungsform beträgt
a) die Länge der Kontaktfinger zwischen 10 und 50 mm, bevorzugt zwischen 15 und 30 mm, besonders bevorzugt zwischen 20 und 25 mm und/oder
b) die Breite der Kontaktfinger in x-Richtung zwischen 0,05 und 2,0 mm, bevorzugt zwischen 0,1 und 1,0 mm, besonders bevorzugt zwischen 0,15 und 0,6 mm.

Bevorzugt ist weiterhin, wenn die Schiene sehr schmal ausgebildet ist, d.h. dass die Stromsammelschiene und/oder die Kontaktfinger in y-Richtung weniger als 1,0 mm, bevorzugt weniger als 0,5 mm, besonders bevorzugt zwischen 0,05 und 0,3 mm, insbesondere zwischen 0,08 und 0,15 mm dick sind. Dabei weist die Stromsammelschiene in y-Richtung bevorzugt die gleiche Dimensionierung wie die Kontaktfinger auf. Beide Bereiche der erfindungsgemäßen Schiene sind z.B. als gleich dicke Folie mit einer beispielhaften Dicke von 0,1 mm ausgebildet.

Eine weitere Ausgestaltung der Schiene sieht vor, dass sie über 5 bis 500, bevorzugt über 10 bis 200 Kontaktfinger umfasst.

Hinsichtlich der in Frage kommenden Materialien ist es vorteilhaft, wenn die Stromsammelschiene sowie die Kontaktfinger aus einem elektrisch leitfähigen Material, insbesondere einem Metall, wie z.B. Kupfer, Silber und/oder Legierungen hieraus sowie Kupfer und Beryllium enthaltende Legierungen, gebildet ist.

Weiter ist es möglich, wenn zumindest die Kontaktfinger zumindest bereichsweise, insbesondere zumindest im Bereich der Kontaktstellen, eine elektrisch leitfähige Beschichtung, insbesondere eine Goldbeschichtung, aufweisen.

Unter herstellungstechnischen Aspekten ist es insbesondere bevorzugt, wenn die Stromsammelschiene und die Kontaktfinger einstückig ausgebildet sind.

Eine weitere bevorzugte Ausführungsform der vorliegenden Erfindung sieht vor, dass die Stromsammelschiene zur mechanischen Stabilisierung in y-Richtung durch mindestens eine mit der Stromsammelschiene form- und/oder kraftschlüssig verbundene elektrisch leitfähige Platte, bevorzugt durch zwei beidseitig in y-Richtung mit der Stromsammelschiene form- und/oder kraftschlüssig verbundene elektrisch leitfähige Platten, verstärkt ist. Die Verbindung der form- oder kraftschlüssig mit der Schiene verbundenen elektrischen leitfähigen Platten kann dabei zum Beispiel durch Löten, Kleben, aber auch durch mechanische Verbindungen, wie beispielsweise Schrauben oder Nieten, bewerkstelligt werden. Die Platte bzw. die Platten dienen dabei der mechanischen Verstärkung der erfindungsgemäßen Schiene, insbesondere im Bereich der Stromsammelschiene.

Dabei ist es vorteilhaft, wenn die Platte oder die Platten eine Dicke in y-Richtung zwischen 0,1 und 2 mm, bevorzugt zwischen 0,3 und 0,5 mm aufweisen. Insbesondere ist dabei die Platte oder die Platten aus dem gleichen Material wie die Schiene gebildet. Hierzu wird auf die oben genannte Materialauswahl verwiesen.

Besonders bevorzugt ist, wenn die Schiene zumindest bereichsweise mit Ausnahme der Bereiche, die der elektrischen Kontaktierung dienen, mit einer Schutzschicht und/oder einer reflexionsreduzierenden Schicht, insbesondere einer Lackschicht, überzogen ist. Insbesondere kommen hierzu Emissionsgradlacke, beispielsweise das Fabrikat TETNAL® oder das Fabrikat SENOTHERM® der Firma InfraTech GmbH zum Einsatz.

Erfindungsgemäß wird ebenso ein Verfahren zur Herstellung einer im Voranstehenden beschriebenen Schiene angegeben, bei der aus einem Rohling z.B. einer Platine für die Schiene mittels eines Materialabtragsschrittes Material entfernt wird, so dass die Anordnung der Kontaktfinger entsteht. Als Rohling für die erfindungsgemäße Schiene kommt beispielsweise ein entsprechend aus einem leitfähigen Material gebildeter Materialstreifen oder eine entsprechende Platine mit einer länglichen Ausdehnung (x-Richtung), Ausdehnung in der Breite (z-Richtung) sowie einer gewissen Dicke (y-Richtung) in Frage. In dem Bereich des Rohlings, in dem die Kontaktfinger entstehen sollen, wird nun bereichsweise eine Durchtrennung des Rohlings in der x-/y-Ebene vorgenommen, so dass voneinander separierte Kontaktfinger in der x-/z-Richtung entstehen. In dem Bereich, in dem die Stromsammelschiene ausgebildet werden soll, wird der Rohling nicht bearbeitet. Es können jedoch auch in diesem Bereich zusätzliche Durchtrennungen, z.B. Bohrungen, etc., in den Materialstreifen eingebracht werden, um beispielsweise verstärkende Platten an der Stromsammelschiene zu fixieren. Alle zuvor beschriebenen bevorzugten geometrischen Ausgestaltungen der Kontaktfinger können durch das erfindungsgemäße Verfahren bewerkstelligt werden.

Der Materialabtrag kann dabei direkt erfolgen, indem beispielsweise mit entsprechenden Laserablationsverfahren oder mechanischen Materialabtragsverfahren gearbeitet wird, ebenso kann der Materialabtrag durch entsprechende Ätzverfahren erfolgen. Hierzu wird der Rohling beispielsweise mit einer entsprechenden Ätzmaske versehen, die an den Stellen, an denen der Materialabtrag erfolgen soll, ausgespart wird.

Ferner wird erfindungsgemäß ein Verfahren zur Überprüfung einer Solarzelle angegeben, bei dem eine Solarzelle mit mindestens zwei zuvor beschriebenen Schienen über die Kontaktfinger elektrisch kontaktiert wird, indem eine elektrische Kontaktierung der Busbars vorgenommen wird, und anschließend die Solarzelle geflasht und/oder zur Photolumineszenz und/oder zur Elektrolumineszenz angeregt und/oder vermessen wird. Dabei wird zumindest ein Schienenpaar zur elektrischen Kontaktierung einer Solarzelle benötigt. Die Schienen werden derart mit der Solarzelle kontaktiert, dass die Spitzen der Kontaktfinger mit dem Substrat, d.h. der Solarzelle, in Berührung gebracht werden. Bevorzugt wird die Schiene so auf der Solarzelle arrangiert, dass die Abschattung der Solarzelle durch die Schiene möglichst minimal ist.

Bei Solarzellen, die beispielsweise zwei Busbars aufweisen, kann eine Kontaktierung der Solarzelle auch mittels dreier der erfindungsgemäßen Schienen erfolgen. Dabei kann beispielsweise jeder der zwei auf der Vorderseite vorhandenen Busbars mit jeweils einer Schiene kontaktiert werden, zusätzlich wird auch der Rückseitenkontakt der Solarzelle mit einer entsprechenden Schiene kontaktiert.

Eine analoge Vorgehensweise ist ebenso für Solarzellen mit drei Busbars denkbar, auch hier kann ein jeder der Busbars mit jeweils einer Kontaktschiene kontaktiert werden.

Die vorliegende Erfindung wird anhand der nachfolgend dargestellten Ausführungsformen sowie der beigefügten Figur näher beschrieben, ohne die Erfindung auf die dort dargestellten speziellen Ausführungsformen zu beschränken.

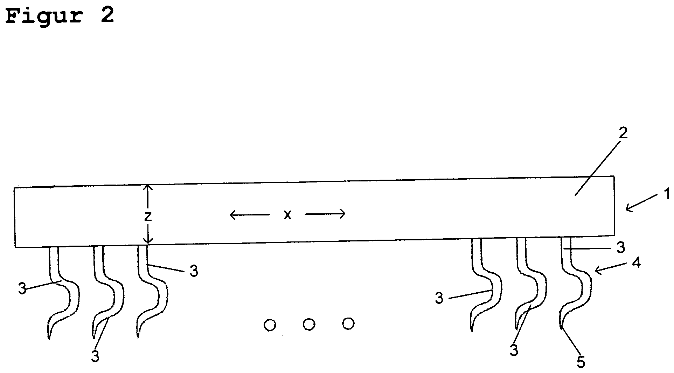

In Figur 2 ist eine erste erfindungsgemäße Ausgestaltung der erfindungsgemäßen Schiene 1, die aus einer Stromsammelschiene 2 sowie mehreren einseitig an der Stromsammelschiene 2 angeordneten Kontaktfingern 3 gebildet ist, dargestellt. Die Schiene 1 weist dabei eine längliche Dimensionierung (x-Richtung, in der Figur dargestellt) sowie eine entsprechende Dimensionierung in z-Richtung (ebenso durch den entsprechenden Richtungsvektor in der Figur angedeutet) auf. Nicht dargestellt ist die Dimensionierung (Dicke) der Schiene 1 in y-Richtung; diese verläuft in die Zeichnungsebene hinein. Die Federwirkung der Federkontakte in z-Richtung wird nun dadurch bewerkstelligt, dass jeder der Kontaktfinger 3 einen nicht geradlinigen Verlauf aufweist, im vorliegenden Fall beispielsweise in Form einer bogenförmigen Aussparung oder eines gekrümmten Bereichs 4. Wird eine derartige Schiene nun in z-Richtung über die Spitzen 5 der Kontaktfinger 3 mit einem zu kontaktierenden Substrat elektrisch kontaktiert, kann die wirkende Kraft auf die Kontaktfinger bzw. das zu kontaktierende Substrat dadurch aufgenommen werden, dass sich jeder der Kontaktfinger 3 durch die vorgegebene Krümmung 4 leichter verformen lässt.

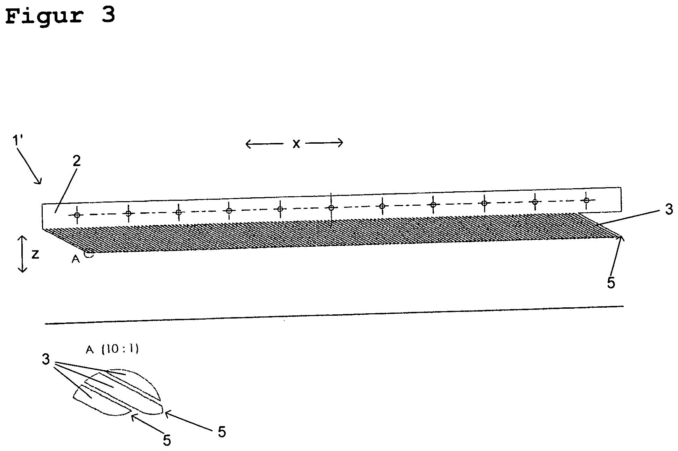

In Figur 3 ist eine weitere Ausgestaltungsform der Schiene 1' gemäß der vorliegenden Erfindung dargestellt. Auch hier ist eine Stromsammelschiene 2 vorgesehen, an die einseitig mehrere Kontaktfinger 3 angeordnet sind. Sowohl die Stromsammelschiene 2 als auch die hiervon abzweigenden Kontaktfinger 3 sind dabei in der in Figur 3 dargestellten x-/z-Ebene ausgebildet. Die Schiene 1 weist insgesamt eine gewisse Dicke auf, die in die Bildebene (y-Richtung, nicht dargestellt) verläuft. Die Federwirkung einer derartigen erfindungsgemäßen Ausführungsform der Schiene 1 ist dadurch bewerkstelligt, dass die Kontaktfinger 3 in einem gewissen Winkel, der kleiner 90° ist, zur x-Richtung der Stromsammelschiene 2 an diese angeordnet sind. Durch diesen abgewinkelten Verlauf der Kontaktfinger 3 bezüglich der Stromsammelschiene 2 kann ebenso bei Kontaktierung der Schiene 1 über die Spitzen 5 der Kontaktfinger 3 mit einem zu kontaktierenden Substrat durch entsprechende Kraftaufnahme und Deformation der Kontaktfinger 3 eine Federwirkung herbeigeführt werden. Die Federwirkung kann über den Winkel beeinflusst werden. Ein kleinerer Winkel erhöht die Federwirkung.

Die zuvor beschriebenen Kontaktschienen reduzieren die Messabweichung durch den seriellen Widerstand des Busbars. Weiterhin reduzieren diese die Abschattung der Zelle. Bei gleich vielen Kontaktpunkten ist eine Kontaktierung über die Kontaktschiene günstiger gegenüber einer Kontaktierung mit Kontaktstiften. Außerdem ist auf einfache Weise eine Flexibilität in der Anordnung der zellseitigen Kontaktpads zu realisieren.

Für die Kontaktierung wird z.B. ein geätztes und elektrisch leitfähiges Material mit einer Au-Schicht verwendet. Zur mechanischen Stabilisierung dieser Folie wird dieses mit einem oder mehreren dünnen und elektrisch leitenden Blechen, bevorzugt aus demselben Werkstoff wie die Schiene, verlötet. Da diese Bleche den Querschnitt der Stromführung vergrößern, verringert sich der Spannungsabfall über der Schiene. Dadurch, dass sehr dünne Materialen verwendet werden, fällt die Kontaktierung dünner aus als herkömmliche Kontaktierungsvarianten. Ist die Kontaktierung breiter als der Busbar, wird ein Teil der Solarzelle verschattet. Dies verfälscht das Messergebnis und führt durch den Schattenwurf bei der EL zum Informationsverlust.

Mit Hilfe dieser Erfindung können Solarzellen ohne (oder mit) Zellverbinder elektrisch kontaktiert und z.B. per EL oder Flasher untersucht werden.

Neben dem Materialkostenvorteil reduziert die Kontaktschiene gegenüber herkömmlichen Kontaktierungsvarianten die Verschattung und durch die dicht liegenden Kontaktpunkte den Messfehler durch den seriellen Widerstand des Busbars.

## Patentansprüche

1. Schiene (1) für die elektrische Kontaktierung eines elektrisch leitfähigen Substrates, umfassend eine in x-Richtung länglich ausgebildete und in y-Richtung eine Dicke aufweisende Stromsammelschiene (2), die eine Mehrzahl von einseitig an der Stromsammelschiene (2) angeordneten Kontaktfingern (3), die eine Richtungskomponente in Richtung der herzustellenden Kontaktierung (z-Richtung) aufweisen, umfasst, wobei die Stromsammelschiene (2) und die Kontaktfinger (3) einstückig ausgebildet sind,
**dadurch gekennzeichnet,**
**dass** die Kontaktfinger (3) in z-Richtung federnd ausgestaltet sind.

2. Schiene (1) nach Anspruch 1, **dadurch gekennzeichnet, dass** die federnde Ausgestaltung der Kontaktfinger (3) dadurch bedingt ist, dass der Winkel, der zwischen der x-Richtung und dem Verlauf der Kontaktfinger (3) ausgebildet ist, zwischen 10° und 70°, bevorzugt zwischen 15° und 50°, weiter bevorzugt zwischen 20 und 40°, besonders bevorzugt zwischen 25° und 35° beträgt.

3. Schiene (1) nach einem der vorhergehenden Ansprüche, **dadurch gekennzeichnet, dass** die federnde Ausgestaltung der Kontaktfinger (3) dadurch bedingt ist, dass die Kontaktfinger (3) einen nicht geradlinigen Verlauf (4), insbesondere einen geschwungenen oder bogenförmigen Verlauf aufweisen.

4. Schiene (1) nach einem der vorhergehenden Ansprüche, **dadurch gekennzeichnet, dass** die Spitzen (5) der Kontaktfinger (3) abgerundet und/oder abgeflacht ausgestaltet sind.

5. Schiene (1) nach einem der vorhergehenden Ansprüche, **dadurch gekennzeichnet, dass** die Kontaktfinger (3) parallel und/oder äquidistant angeordnet sind.

6. Schiene (1) nach einem der vorhergehenden Ansprüche, **dadurch gekennzeichnet, dass** der Abstand der Kontaktfinger (3) zueinander weniger als 2 mm, bevorzugt weniger als 1 mm, besonders bevorzugt zwischen 0,05 und 0,5 mm, insbesondere zwischen 0,12 und 0,15 mm beträgt.

7. Schiene (1) nach einem der vorhergehenden Ansprüche, **dadurch gekennzeichnet, dass** die Länge aller Kontaktfinger (3) gleich ist.

8. Schiene (1) nach einem der vorhergehenden Ansprüche, **dadurch gekennzeichnet, dass**
a) die Länge der Kontaktfinger (3) zwischen 10 und 50 mm, bevorzugt zwischen 15 und 30 mm, besonders bevorzugt zwischen 20 und 25 mm beträgt und/oder
b) die Breite der Kontaktfinger (3) in x-Richtung zwischen 0,05 und 2,0 mm, bevorzugt zwischen 0,1 und 1,0 mm, besonders bevorzugt zwischen 0,15 und 0,6 mm beträgt.

9. Schiene (1) nach einem der vorhergehenden Ansprüche, **dadurch gekennzeichnet, dass** die Stromsammelschiene (2) und/oder die Kontaktfinger (3) in y-Richtung weniger als 1,0 mm, bevorzugt weniger als 0,5 mm, besonders bevorzugt zwischen 0,05 und 0,3 mm, insbesondere zwischen 0,08 und 0,15 mm dick sind.

10. Schiene (1) nach einem der vorhergehenden Ansprüche, **dadurch gekennzeichnet, dass** sie über 5 bis 500, bevorzugt über 10 bis 200 Kontaktfinger (3) umfasst.

11. Schiene (1) nach einem der vorhergehenden Ansprüche, **dadurch gekennzeichnet, dass** die Stromsammelschiene (2) sowie die Kontaktfinger (3) aus einem elektrisch leitfähigen Material, insbesondere einem Metall, wie z.B. Kupfer, Silber und/oder Legierungen hieraus, sowie Kupfer und Beryllium enthaltende Legierungen, gebildet ist.

12. Schiene (1) nach einem der vorhergehenden Ansprüche, **dadurch gekennzeichnet, dass** zumindest die Kontaktfinger (3) zumindest bereichsweise, insbesondere zumindest im Bereich der Kontaktstellen (4), eine elektrisch leitfähige Beschichtung, insbesondere eine Goldbeschichtung aufweisen.

13. Schiene (1) nach einem der vorhergehenden Ansprüche, **dadurch gekennzeichnet, dass** die Stromsammelschiene (2) zur mechanischen Stabilisierung in y-Richtung durch mindestens eine mit der Stromsammelschiene (2) form- und/oder kraftschlüssig verbundene elektrisch leitfähige Platte, bevorzugt durch zwei beidseitig in y-Richtung mit der Stromsammelschiene form- und/oder kraftschlüssig verbundene elektrisch leitfähige Platten, verstärkt ist.

14. Schiene (1) nach vorhergehendem Anspruch, **dadurch gekennzeichnet, dass** die Platte oder die Platten eine Dicke in y-Richtung zwischen 0,1 und 2 mm, bevorzugt zwischen 0,3 und 0,5 mm aufweisen.

15. Schiene (1) nach einem der vorhergehenden Ansprüche, **dadurch gekennzeichnet, dass** die Schiene (1) zumindest bereichsweise mit Ausnahme der Bereiche, die der elektrischen Kontaktierung dienen, mit einer Schutzschicht und/oder einer reflexionsreduzierenden Schicht, insbesondere einer Lackschicht überzogen ist.

16. Verfahren zur Herstellung einer Schiene (1) nach einem der vorhergehenden Ansprüche, mittels eines Materialabtragsschrittes, insbesondere eines Ätzprozesses, durch Laserablation und/oder durch mechanische Materialabtragsschritte, wie z.B. Stanzen aus einem Schienenrohling Material derart entfernt wird, dass die Mehrzahl der Kontaktfinger (3) ausgebildet wird.

17. Verfahren zur Überprüfung einer Solarzelle, bei dem eine Solarzelle mit mindestens zwei Schienen (1) nach einem der Ansprüche 1 bis 14 über die Kontaktfinger (3) elektrisch kontaktiert wird, indem eine elektrische Kontaktierung der Busbars vorgenommen wird, und anschließend die Solarzelle geflasht und/oder zur Photolumineszenz und/oder zur Elektrolumineszenz angeregt und/oder vermessen wird.

## Claims

1. Bar (1) for the electrical contacting of an electrically conductive substrate, comprising a current-collecting bar (2) which has an elongated configuration in the x-direction and has a thickness in the y-direction and which bar comprises a plurality of contact fingers (3) which are disposed on the current-collecting bar (2) on one side and have a directional component in the direction of the contacting to be produced (z-direction), the current-collecting bar (2) and the contact fingers (3) being integrally formed,
***characterised in that***
the contact fingers (3) are configured resiliently in the z-direction.

2. Bar (1) according to claim 1, **characterised in that** the resilient configuration of the contact fingers (3) is caused by the angle which is formed between the x-direction and the course of the contact fingers (3) being between 10° and 70°, preferably between 15° and 50°, further preferred between 20° and 40°, particularly preferred between 25° and 35°.

3. Bar (1) according to one of the preceding claims, **characterised in that** the resilient configuration of the contact fingers (3) is caused by the contact fingers (3) having a non-linear course (4), in particular a curved or arcuate course.

4. Bar (1) according to one of the preceding claims, **characterised in that** the tips (5) of the contact fingers (3) have a rounded and/or flattened configuration.

5. Bar (1) according to one of the preceding claims, **characterised in that** the contact fingers (3) are disposed parallel and/or equidistant.

6. Bar (1) according to one of the preceding claims, **characterised in that** the spacing of the contact fingers (3) relative to each other is less than 2 mm, preferably less than 1 mm, particularly preferred between 0.05 and 0.5 mm, in particular between 0.12 and 0.15 mm.

7. Bar (1) according to one of the preceding claims, **characterised in that** the length of all the contact fingers (3) is equal.

8. Bar (1) according to one of the preceding claims, **characterised in that**
a) the length of the contact fingers (3) is between 10 and 50 mm, preferably between 15 and 30 mm, particularly preferred between 20 and 25 mm and/or
b) the width of the contact fingers (3) in the x-direction is between 0.05 and 2.0 mm, preferably between 0.1 and 1.0 mm, particularly preferred between 0.15 and 0.6 mm.

9. Bar (1) according to one of the preceding claims, **characterised in that** the current-collecting bar (2) and/or the contact fingers (3) have a thickness in the y-direction of less than 1.0 mm, preferably less than 0.5 mm, particularly preferred between 0.05 and 0.3 mm, in particular between 0.08 and 0.15 mm.

10. Bar (1) according to one of the preceding claims, **characterised in that** it comprises over 5 to 500, preferably over 10 to 200, contact fingers (3).

11. Bar (1) according to one of the preceding claims, **characterised in that** the current-collecting bar (2) and the contact fingers (3) are formed from an electrically conductive material, in particular a metal, such as e.g. copper, silver and/or alloys hereof, and alloys comprising copper and beryllium.

12. Bar (1) according to one of the preceding claims, **characterised in that** at least the contact fingers (3), at least in regions, in particular at least in the region of the contact points (4), have an electrically conductive coating, in particular a gold coating.

13. Bar (1) according to one of the preceding claims, **characterised in that** the current-collecting bar (2) is reinforced for mechanical stabilisation in the y-direction by at least one electrically conductive plate which is connected to the current-collecting bar (2) in a form fit and/or frictionally, preferably by two electrically conductive plates which are connected on both sides in the y-direction to the current-collecting bar in a form fit and/or frictionally.

14. Bar (1) according to the preceding claim, **characterised in that** the plate or the plates have a thickness in the y-direction between 0.1 and 2 mm, preferably between 0.3 and 0.5 mm.

15. Bar (1) according to one of the preceding claims, **characterised in that** the bar (1) is covered, at least in regions, with the exception of the regions which serve for electrical contacting, with a protective layer and/or a reflection-reducing layer, in particular a layer of paint.

16. Method for the production of a bar (1) according to one of the preceding claims, by means of a material removal step, in particular an etching process, by laser ablation and/or by mechanical material removal steps, such as e.g. stamping from a bar blank material such that the plurality of contact fingers (3) is formed.

17. Method for testing a solar cell, in the case of which a solar cell is contacted electrically by at least two bars (1) according to one of the claims 1 to 14 via the contact fingers (3) by an electrical contacting of the busbars being undertaken, and subsequently the solar cell is flashed and/or excited to photoluminescence and/or to electroluminescence and/or measured.

## Revendications

1. Rail (1) pour la mise en contact électrique d'un substrat électriquement conducteur, comprenant un rail collecteur de courant (2) conçu longitudinalement dans la direction x et présentant une épaisseur dans la direction y, qui comprend une pluralité de doigts de contact (3) disposés sur un côté du rail collecteur de courant (2), qui présentent une composante de direction en direction de la mise en contact à réaliser (direction z), le rail collecteur de courant (2) et les doigts de contact (3) étant réalisés d'une seule pièce,
**caractérisé en ce que**
les doigts de contact (3) sont conçus de manière élastique dans la direction z.

2. Rail (1) selon la revendication 1, **caractérisé en ce que** la conception élastique des doigts de contact (3) est conditionnée par le fait que l'angle qui est formé entre la direction x et l'extension des doigts de contact (3) est compris entre 10° et 70°, de préférence entre 15° et 50°, de préférence entre 20° et 40°, et plus préférentiellement entre 25° et 35°.

3. Rail (1) selon l'une des revendications précédentes, **caractérisé en ce que** la conception élastique des doigts de contact (3) est conditionnée par le fait que les doigts de contact (3) présentent une extension non linéaire (4), plus particulièrement une extension galbée ou en forme d'arc de cercle.

4. Rail (1) selon l'une des revendications précédentes, **caractérisé en ce que** les pointes (5) des doigts de contact (3) sont arrondies et/ou aplaties.

5. Rail (1) selon l'une des revendications précédentes, **caractérisé en ce que** les doigts de contact (3) sont disposés parallèlement et/ou de manière équidistante.

6. Rail (1) selon l'une des revendications précédentes, **caractérisé en ce que** la distance des doigts de contact (3) entre eux est inférieure à 2 mm, de préférence inférieure à 1 mm, de préférence comprise entre 0,05 et 0,5 mm, plus particulièrement comprise entre 0,12 et 0,15 mm.

7. Rail (1) selon l'une des revendications précédentes, **caractérisé en ce que** la longueur de tous les doigts de contact (3) est identique.

8. Rail (1) selon l'une des revendications précédentes, **caractérisé en ce que**
a) la longueur des doigts de contact (3) est comprise entre 10 et 50 mm, de préférence entre 15 et 30 mm, de préférence entre 20 et 25 mm et/ou
b) la largeur des doigts de contact (3) dans la direction x est comprise entre 0,05 et 2,0 mm, de préférence entre 0,1 et 1,0 mm, de préférence entre 0,15 et 0,6 mm.

9. Rail (1) selon l'une des revendications précédentes, **caractérisé en ce que** le rail collecteur de courant (2) et/ou les doigts de contact (3) présentent une épaisseur dans la direction y inférieure à 1,0 mm, de préférence inférieure à 0,5 mm, de préférence entre 0,05 et 0,3 mm, plus particulièrement entre 0,08 et 0,15 mm.

10. Rail (1) selon l'une des revendications précédentes, **caractérisé en ce qu'**il comprend plus de 5 à 500, de préférence plus de 10 à 200 doigts de contact (3).

11. Rail (1) selon l'une des revendications précédentes, **caractérisé en ce que** le rail collecteur de courant (2) ainsi que les doigts de contact (3) sont constitués d'un matériau électriquement conducteur, plus particulièrement d'un métal, comme du cuivre, de l'argent et/ou d'alliages de ceux-ci, ainsi que d'alliages contenant du cuivre et du béryllium.

12. Rail (1) selon l'une des revendications précédentes, **caractérisé en ce qu'**au moins les doigts de contact (3) comprennent, au moins à certains endroits, plus particulièrement au moins au niveau des points de contact (4), un revêtement électriquement conducteur, plus particulièrement un revêtement d'or.

13. Rail (1) selon l'une des revendications précédentes, **caractérisé en ce que** le rail collecteur de courant (2) est renforcé, pour la stabilisation mécanique dans la direction y, par au moins une plaque électriquement conductrice reliée par complémentarité de forme et/ou par force avec le rail collecteur de courant (2), de préférence par deux plaques électriquement conductrices reliées par complémentarité de forme et/ou par force des deux côtés dans la direction y avec le rail collecteur de courant.

14. Rail (1) selon l'une des revendications précédentes, **caractérisé en ce que** la plaque ou les plaques présentent une épaisseur dans la direction y comprise entre 0,1 et 2 mm, de préférence entre 0,3 et 0,5 mm.

15. Rail (1) selon l'une des revendications précédentes, **caractérisé en ce que** le rail (1) est recouvert, au moins à certains endroits, à l'exception des zones qui permettent la mise en contact électrique, d'une couche protectrice et/ou d'une couche réduisant la réflexion, plus particulièrement d'une couche de peinture.

16. Procédé de fabrication d'un rail (1) selon l'une des revendications précédentes, du matériau étant éliminé au moyen d'une étape d'enlèvement de matière, plus particulièrement d'un processus de gravure, par ablation au laser et/ou par des étapes d'enlèvement de matière mécanique, comme l'estampage, à partir d'une ébauche de rail, de façon à ce que la pluralité des doigts de contact (3) soient réalisés.

17. Procédé de vérification d'une cellule photovoltaïque, dans lequel une cellule photovoltaïque est mise en contact électrique avec au moins deux rails (1) selon l'une des revendications 1 à 14 par l'intermédiaire des doigts de contact (3), grâce au fait qu'une mise en contact électrique des barres de bus est effectuée puis la cellule photovoltaïque est flashée et/ou est excitée afin d'obtenir une photoluminescence et/ou une électroluminescence et/ou est mesurée.
